Europäisches Patentamt

**European Patent Office**

Office européen des brevets

(19)

(11) Numéro de publication: **0 178 216**
**B1**

(12) **FASCICULE DE BREVET EUROPEEN**

(45) Date de publication du fascicule du brevet:
06.12.89

(51) Int. Cl.⁴: **G01N 24/06,** H01F 5/00,
H01F 7/20

(21) Numéro de dépôt: **85401895.9**

(22) Date de dépôt: **27.09.85**

(54) **Système de bobines de production de champs additionnels pour l'obtention, dans un aimant comportant des pièces polaires de polarisation pour imagerie par résonance magnétique nucléaire, de champs de polarisation à gradients constants.**

(30) Priorité: **05.10.84 FR 8415301**

(43) Date de publication de la demande:
**16.04.86 Bulletin 86/16**

(45) Mention de la délivrance du brevet:
**06.12.89 Bulletin 89/49**

(84) Etats contractants désignés:
**DE GB NL**

(56) Documents cités:
**EP-A- 0 006 443**
**EP-A- 0 013 782**
**EP-A- 0 086 560**
**FR-A- 2 301 068**
**US-A- 3 515 979**

(73) Titulaire: **COMMISSARIAT A L'ENERGIE ATOMIQUE,**
**31/33, rue de la Fédération, F-75015 Paris(FR)**

(72) Inventeur: **Briguet, André, 14, Avenue Condorcet,**
**F-69100 Villeurbanne(FR)**
Inventeur: **Jeandey, Christian, Chemin Flancey Le Muret,**
**F-38120 Saint Egreve(FR)**
Inventeur: **Tournier, Edmond, 2, Place Léon Martin,**
**F-38000 Grenoble(FR)**

(74) Mandataire: **Mongrédien, André et al, c/o**
**BREVATOME 25, rue de Ponthieu, F-75008 Paris(FR)**

## Description

La présente invention se rapporte aux techniques d'imagerie par la méthode dite de résonance magnétique nucléaire (RMN) actuellement en voie de développement rapide, notamment pour l'examen du corps humain, dont elle permet d'obtenir des images d'une qualité et d'une précision inconnues jusqu'ici avec les méthodes de la radiologie classique aux rayons X.

La méthode d'imagerie RMN utilise la propriété de résonance magnétique nucléaire de certains noyaux présents dans le corps humain, essentiellement les protons répartis dans tout l'organisme, et quelques noyaux d'intérêt biologique mais en abondance beaucoup moins grande tels que le phosphore ($^{31}P$), le potassium ($^{39}K$), le sodium ($^{23}Na$).

Une installation de RMN médicale se compose principalement d'un aimant destiné à produire dans toute la zone du corps à examiner un champ magnétique de polarisation

$$\vec{B_o},$$

statique et uniforme, auquel on superpose, à l'aide d'une bobine auxiliaire, un champ tournant de radiofréquence dans un plan perpendiculaire à la direction du champ

$$\vec{B_o}$$

précédent.

Les images sont obtenues en faisant résonner les noyaux d'hydrogène ou protons, contenus dans les tissus biologiques. Cette résonance est possible parce que chaque proton se comporte comme un microscopique aimant. En effet, lorsque l'on applique le champ statique

$$\vec{B_o},$$

les spins s'orientent tous parallèlement à l'axe du champ. Ils n'ont donc plus que deux orientations possibles : dans le sens du champ ou en sens contraire. Lorsqu'on applique en plus le champ tournant à une fréquence quelconque, il ne se passe rien. Mais si cette fréquence est choisie égale ou très voisine de $f_o$, telle que $2\pi f_o = \gamma B_o$, formule dans laquelle $\gamma$ est une constante physique caractéristique des noyaux que l'on veut mettre en résonance et dénommée rapport gyromagnétique, le couplage des spins et du champ tournant atteint une valeur telle que ceux-ci entrent en résonance.

Le signal de résonance détecté est proportionnel à l'aimantation des noyaux placés dans le champ magnétique

$$\vec{B_o}$$

de polarisation. L'observation du phénomène de résonance requiert donc la présence d'un champ magnétique élevé (de 0,1 à 1 tesla) et de très grande uniformité dans tout le volume à imager.

L'image de résonance magnétique proprement dite, qui constitue la finalité médicale de l'exploration du patient, est ensuite construite progressivement par codage spatial à l'aide d'un ordinateur. Pour ce faire, plusieurs méthodes connues existent, notamment de constructions de l'image par points, par lignes et par plans, sur le détail desquels il n'est pas nécessaire de revenir ici ; il suffira de savoir, pour la compréhension du présent texte, qu'elles impliquent toutes la superposition au champ de polarisation

$$\vec{B_o}$$

et successivement dans le temps d'un grand nombre de champs complémentaires de durées et d'amplitudes très faibles, variables dans les trois directions (x, y et z) de l'espace, pour créer avec

$$\vec{B_o}$$

un champ résultant

$$\vec{B}$$

dont la composante

$$\vec{B_z}$$

a des gradients spatiaux

$$\frac{\partial B_z}{\partial x}, \quad \frac{\partial B_z}{\partial y}$$

et

$$\frac{\partial B_z}{\partial z}$$

constants selon x, y et z, z étant la direction du champ

$$\vec{B_o}.$$

L'antenne et l'électronique associées pour la réception des différents signaux de résonance des protons ont une bande passante suffisamment large pour recevoir les fréquences de résonance f, voisine de $f_o$, correspondant en chaque point examiné la valeur $2\pi f = \gamma B$, B étant le module du champ résultant en ce point, par définition voisin de

$$\vec{B_o}.$$

A titre indicatif, le champ

$$\vec{B_o}$$

a une valeur de 0,1 à 1 tesla et les gradients

$$\frac{\partial Bz}{\partial x}, \quad \frac{\partial Bz}{\partial y} \quad et \quad \frac{\partial Bz}{\partial z}$$

ont un ordre de grandeur de $10^{-1}$ à $10^{-2}$ tesla/mètre sur une longueur moyenne de $\pm\,20$ cm environ. Egalement à titre indicatif, il faut 6 minutes environ par cette méthode pour construire une coupe de $128 \times 128$ points, ce qui correspond à l'établissement de 128 gradients de codage différents. Les machines modernes permettent d'obtenir plusieurs coupes (4 à 6) simultanément.

L'aimant utilisé pour créer le champ magnétique

$$\vec{Bo}$$

de polarisation peut être, selon les cas, soit un électroaimant, avec ou sans circuit magnétique, soit un aimant permanent, chacune de ces solutions présentant certains avantages et inconvénients spécifiques.

Lorsqu'il s'agit d'un électroaimant, ce dernier se compose le plus souvent de simples bobines hélicoïdales dans l'air, à l'exclusion de tout circuit magnétique, dont le diamètre d'enroulement est prévu avec une dimension suffisante pour entourer le crâne du patient ou son corps et tous les accessoires nécessaires (antenne, bobines de gradient,...). Ces bobines produisent alors un champ

$$\vec{Bo}$$

de polarisation qui traverse le patient des pieds à la tête selon l'axe de son corps.

Lorsqu'il s'agit d'un aimant permanent, la présence d'un circuit magnétique oblige à loger le patient dans un tunnel défini par la carcasse de l'aimant et l'induction de polarisation

$$\vec{Bo}$$

traverse alors généralement le corps du patient de la poitrine vers le dos selon une direction sagittale.

La présente invention se rapporte précisément au domaine des dispositifs de production des gradients de champ magnétique linéaires dans des aimants, permanents ou électroaimants, possédant des pièces polaires de forte perméabilité et s'applique particulièrement bien, encore que de façon non limitative, aux aimants permanents du type de ceux qui font l'objet de la demande de brevet française non publiée n° EN 8405903 du 13 avril 1984 et dont on rappellera plus loin la structure. L'invention s'applique donc au cas où le patient couché dans l'entrefer entre une pièce polaire supérieure et une pièce polaire inférieure est traversé par le champ de polarisation selon une direction sagittale identifiée à l'axe Oz.

Les dispositifs de production de champs magnétiques à gradients constants constituent une partie très importante d'un imageur et conditionnent sa structure puisque :

1) - de la qualité des gradients dépend la qualité de l'image, toute variation du gradient entraînant une distorsion de celle-ci,

2) - les dispositifs, généralement des bobines, doivent être placés aussi près que possible de l'objet à imager selon des conditions de linéarité impérieuses (à 1% près dans tout le volume à imager) afin de limiter l'entrefer de l'aimant et par suite le poids donc le coût de la machine, et ce, dans des configurations spatiales telles qu'elles permettent le passage du patient dans ledit entrefer,

3) - le mode de production des champs à gradients constants doit s'intégrer le mieux possible à la structure du circuit magnétique (en l'occurrence aux pièces polaires) pour limiter la puissance des alimentations de courant pulsées, qui peut atteindre quelques dizaines de kW dans les imageurs actuels (résistifs et cryoaimants),

4) - les champs à gradients constants doivent être établis à chaque mesure dans des temps relativement courts, inférieurs à quelques ms.

Pour les systèmes à imagerie RMN à aimants "résistifs" ou supraconducteurs constitués de bobinages, dont les lignes de champ se referment dans l'air, on a recours, pour créer les champs complémentaires produisant des gradients spatiaux constants, à des bobines de correction, calculées pour corriger d'une façon générale les inhomogénéités du champ de polarisation jusqu'au quatrième ordre, ordre par ordre, avec un jeu de bobines pour chaque ordre, et l'on assimile les gradients à des corrections du premier ordre.

Tous ces systèmes s'appuient sur le fait que tout champ magnétique physiquement réalisable peut se développer selon une base de fonctions orthogonales, le plus souvent des harmoniques sphériques de Legendre. Cette procédure permet de profiler le champ à différents ordres, le gradient étant une approximation du champ au premier ordre. L'avantage de cette méthode est que, en théorie, les différents paramètres de réglages associés à un certain ordre (par exemple courant électrique dans un jeu de bobines) n'interagissent pas entre eux, et que le contrôle du champ peut être conduit d'une manière progressive, bien que fastidieuse, jusqu'à des ordres très élevés.

Ces dispositifs sont décrits, en particulier, dans l'article "Magnet field profiling : Analysis and correcting coil design" publié dans "Magnetic Resonance in Medicine" 1,44-65 (1984). Ils sont constitués de bobines montées sur des cylindres entourant le patient et, si l'on voulait appliquer cette technique à des aimants permanents, il faudrait placer les bobines dans l'entrefer, relativement loin des pièces polaires, ce qui conduirait à une diminution inacceptable de la place réservée, dans cet entrefer, au corps du patient.

Pour les systèmes à imagerie RMN à aimants permanents, on ne connaît pas, à l'heure actuelle, les moyens mis en oeuvre par les constructeurs pour produire les gradients de champ linéaires, car ceux-ci ont conservé la confidentialité sur les structures utilisées.

On décrira maintenant une structure connue d'aimant permanent à laquelle s'applique spécialement bien la présente invention et qui a fait l'objet de la demande de brevet français non publiée n° EN 8405903 du 13 avril 1984 au nom du demandeur.

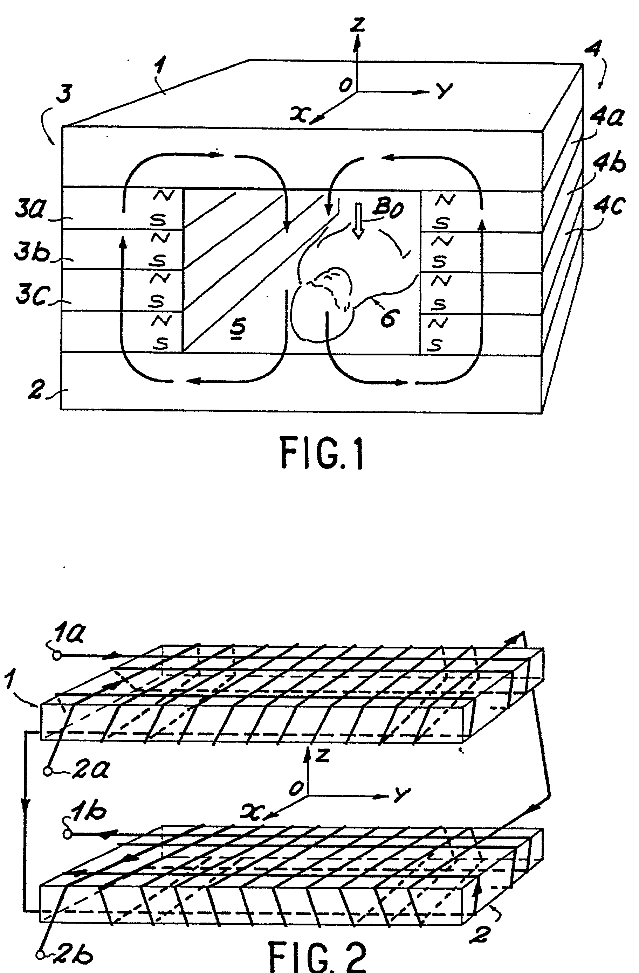

Cette structure connue est représentée sur la figure 1 ci-jointe.

Sur cette figure 1, on a représenté, vu de face en perspective, un système à aimant permanent comportant ses deux pièces polaires supérieure 1 et inférieure 2 de forme générale parallélépipédique rectangle en un matériau ferromagnétique de très forte perméabilité. La structure est complétée latéralement par deux blocs magnétisants 3 et 4 également de forme parallélépipédique rectangle en des matériaux aimantés qui sont le siège de la force magnétomotrice destinée à produire le champ dans l'entrefer 5 en forme de tunnel, délimité précisément par les pièces polaires 1 et 2 et les blocs aimantés 3 et 4. Ces derniers blocs 3 et 4 sont constitués le plus souvent par la juxtaposition de colonnes constituées chacune d'un empilement de briques magnétiques élémentaires telles que 3a, 3b, 3c,... etc 4a, 4b, 4c... etc qui servent ainsi également d'entretoises et de soutien aux pièces polaires 1 et 2. Ces colonnes ne sont pas nécessairement jointives. L'entrefer en forme de tunnel 5 destiné au logement éventuel de tout ou partie d'un corps humain 6, possède, à cet effet, une largeur et une hauteur minimales de l'ordre de 500 mm.

Sur la figure 1, on a représenté par des flèches la répartition du flux magnétique et des lignes de champ dans les blocs aimantés 3 et 4 ainsi que dans les pièces polaires 1 et 2. Comme indiqué sur cette figure 1, l'induction magnétique de polarisation Bo dans le tunnel 5 est dirigée verticalement de haut en bas, c'est-à-dire de la pièce polaire 1 vers la pièce polaire 2, traversant ainsi le corps 6 du patient selon une direction sagittale identifiée, dans toute la suite du présent texte, avec l'axe Oz de repère du trièdre de référence Ox,y,z de la figure 1.

Dans cette configuration, les gradients de la composante Bz selon Oz des différents champs résultants nécessaires à la construction de l'image par codage spatial, à savoir

$$\frac{\partial Bz}{\partial x}, \quad \frac{\partial Bz}{\partial y} \quad et \quad \frac{\partial Bz}{\partial z}$$

doivent être constants et satisfaire les trois égalités suivantes :

$$Bz(x) = \frac{\partial Bz}{\partial x} \cdot x = Gx \cdot x$$

$$Bz(y) = \frac{\partial Bz}{\partial y} \cdot y = Gy \cdot y$$

$$Bz(z) = \frac{\partial Bz}{\partial z} \cdot z = Gz \cdot z$$

dans lesquelles Bz est la composante de l'induction résultante selon l'axe Oz précédemment défini et Gx, Gy, Gz sont les trois gradients constants de l'induction résultante selon les trois directions Ox, Oy et Oz.

La présente invention a précisément pour objet un système de bobines, adaptables notamment à la structure précédente ainsi qu'à tout type d'aimants présentant des pièces polaires flottantes de forte perméabilité, et produisant des champs à gradients constants à ± 1% dans les volumes à imager.

Ce système de bobines de production de champs additionnels dans un aimant comportant deux pièces polaires pour imagerie par résonance magnétique nucléaire dans une configuration où le champ de polarisation

$$\vec{Bo},$$

perpendiculaire aux pièces polaires, est parallèle à la direction Oz d'un trièdre trirectangle de référence, et les pièces polaires, rectangulaires présentent chacune deux faces opposées et ont leurs côtés parallèles aux directions Ox et Oy de ce même trièdre, pour l'obtention de champs de polarisation résultants

$$\vec{B}$$

dont la composante

$$\vec{Bz}$$

selon la direction Oz a des gradients constants Gx, Gy, Gz selon les trois directions de l'espace. Le système conforme à la présente invention est caractérisé selon la partie caractérisante de la revendication 1.

Selon des variantes du système conforme à l'invention, les enroulements de création des gradients $G_x$ et $G_y$ peuvent se présenter sous deux formes différentes.

Dans une première forme, les "retours" de courant sont situés sur la face opposée des conducteurs "aller" et chaque pièce polaire est ainsi en quelque sorte "emmaillotée" par les conducteurs qui parcourent ses deux faces.

Dans une deuxième forme de mise en oeuvre, seuls les conducteurs "aller" sont situés à la surface des pièces polaires, les conducteurs "retour" étant situés en une zone de l'espace éloignée des pièces polaires.

Dans une installation d'imagerie par RMN dans laquelle l'aimant est un aimant permanent muni de pièces polaires, on sait qu'il n'est pas possible d'utiliser les mêmes bobines pour produire le champ de polarisation

$$\vec{Bo}$$

et les champs additionnels superposés à ce champ

$$\vec{Bo}$$

pour effectuer la construction spatiale de l'image. L'invention propose donc un système de bobines particulièrement simple qui permettent de créer, avec une linéarité à 1% près, de tels champs additionnels conduisant à des gradients constants. Dans la structure de cet ensemble de bobines selon l'invention, toutes les bobines sont situées sur les pièces polaires sans aucune perte de place pour le patient qui doit être logé dans le tunnel constitué par le circuit magnétique de l'aimant.

Par ailleurs, les courants qui sont nécessaires pour créer les champs additionnels à gradients constants sont pratiquement égaux à la moitié des intensités de courant qui sont nécessaires pour créer ces mêmes champs additionnels dans les systèmes de l'art antérieur où les bobines créatrices du champ de polarisation sont le plus souvent dans l'air.

Selon l'invention, le système d'enroulements d'axe Oz est composé de deux bobines symétriques situées sur les pièces polaires et conçues chacune de façon telle que l'intensité de courant qui traverse un plan passant par l'axe Oz, entre le centre de la bobine et un point distant de r de cet axe, soit proportionnel à $r^2$.

De façon plus précise encore, lorsque le système d'enroulements d'axe Oz est composé de deux bobines constituées de spires circulaires concentriques, la condition précédente se traduit par le fait que la répartition spatiale de ces spires en fonction du rayon croît de façon telle que la somme totale des spires intérieures à un cercle de rayon r soit proportionnelle à $r^2$.

Selon un mode de mise en oeuvre particulièrement simple du présent système de bobines, les spires de celles-ci sont réparties selon des groupements situés à des distances r, 2r, 3r,... de l'axe Oz, le nombre de spires des groupements successifs étant égal aux termes de la suite des nombres impairs 1, 3, 5... $(2n+1)$. On sait en effet que la somme des nombres impairs de 1 à $2n+1$ est égale à $(n+1)^2$, ce qui est conforme à la caractéristique précédemment énoncée pour le groupement des spires de bobines.

Dans une variante de l'invention, le système d'enroulement d'axe Oz est réalisé à l'aide d'un circuit imprimé en forme de spirale dont l'espacement entre les bandes va en se rétrécissant au fur et à mesure que l'on s'éloigne du centre de façon à respecter la loi de répartition du courant proportionnellement à $r^2$ selon la direction radiale.

Selon une autre variante de réalisation de ce même système de bobines, le système d'enroulements de symétrie circulaire d'axe Oz est constitué de bobines discrètes localisées sur les sections droites de cônes circulaires de sommet 0, centre de l'entrefer, d'axe Oz et de demi-angles au sommet θ.

Dans un premier exemple de mise en oeuvre de cette variante, les bobines au nombre de 2 sur chaque pièce polaire comportent respectivement des nombres de spires dans le rapport de l'ordre de 1 à 8,66 et sont situées sur des cônes de demi-angles au sommet voisins de $\theta_1 = 34°$ et $\theta_2 = 62°$.

Dans une autre réalisation de cette même variante, les bobines, au nombre de trois sur chaque pièce polaire, comportent respectivement des nombres de spires dans les rapports de l'ordre de 1 à 3,89 et 31,85 et sont situées sur des cônes de demi-angles au sommet voisins de $\theta_1 = 26°$, $\theta_2 = 47°$ et $\theta_3 = 69°$.

De toute façon, l'invention sera mieux comprise en se référant à la description qui suit de plusieurs exemples de mise en oeuvre, donnés à titre surtout illustratif et non limitatif, en se référant aux figures 2 à 9 ci-jointes sur lesquelles :

- les figures 2 et 3 représentent en perspective cavalière et en coupe selon un axe Oy un exemple de réalisation des gradients Gx et Gy,
- la figure 4 montre une réalisation possible d'une bobine d'axe Oz pour la création du gradient Gz,
- la figure 5 montre une variante de la bobine précédente dans une réalisation sous forme d'un circuit imprimé,
- la figure 6 montre une autre variante d'une bobine de création du gradient Gz constituée d'un empilement de spires plates,
- la figure 7 est une vue en coupe selon le plan yOz des pièces polaires de l'aimant permanent permettant d'expliquer le fonctionnement des bobines précédentes,
- la figure 8 montre l'exemple d'une réalisation de bobines pour créer le gradient Gz à l'aide de deux bobines discrètes situées sous les pièces polaires,
- la figure 9 montre un exemple de réalisation comportant trois bobines discrètes pour créer ce même gradient Gz.

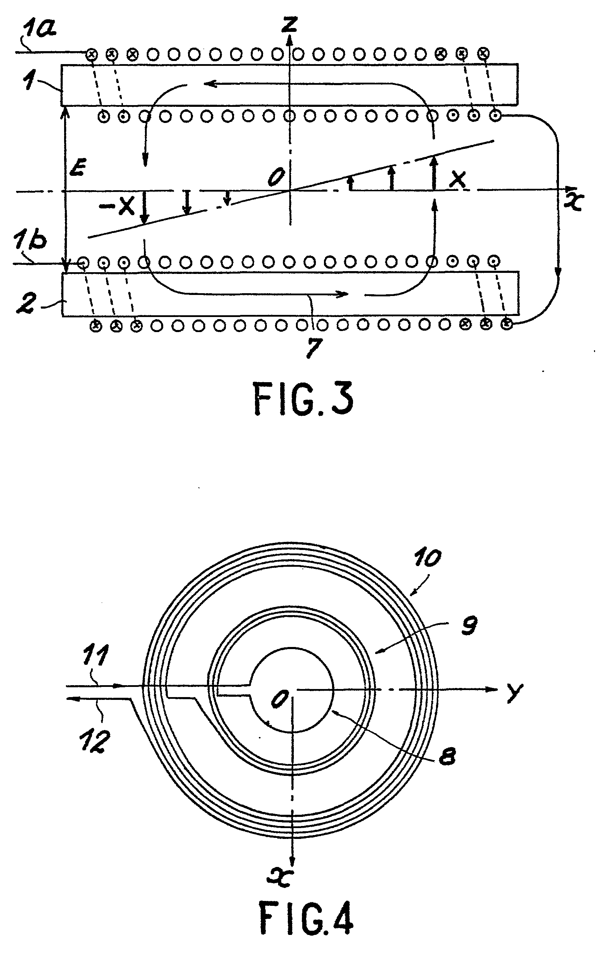

Sur la figure 2, on a représenté schématiquement en perspective cavalière les deux pièces polaires 1 et 2 de l'aimant de la figure 1 sur lequel sont situés les enroulements 1a et 1b de création du gradient Gx et 2a et 2b de création du gradient Gy. Comme on le voit sur cette figure, les bobines 1a et 1b d'une part et 2a et 2b d'autre part sont montées en série et entourent les pièces polaires 1 et 2 de deux nappes de courant constituées de conducteurs parallèles aux directions Ox et Oy et uniformément répartis à la surface des pièces polaires 1 et 2. L'enroulement 2a, 2b qui sert à la création du gradient Gy est orthogonal au premier et est constitué de la même façon par des nappes de conducteurs parallèles uniformément répartis selon l'axe Ox. Conformément à l'invention, et comme on le voit sur la figure 3 pour la bobine 1a et la bobine 1b, les sens de courant sont inversés de l'une à l'autre bobine, c'est-à-dire symétriques par rapport à la direction Ox pour les bobines 1a et 1b et Oy pour les bobines 2a et 2b. Comme on le voit également sur les figures 2 et 3, le retour de courant de chaque conducteur est assuré par une nappe parallèle située de l'autre côté de chaque pièce polaire qui joue ainsi le rôle de noyau magnétique plongé dans un solénoïde à base rectangulaire. Lorsque le courant continu est établi dans les nappes de courant précédent, celui-ci conduit à créer des potentiels magnétiques croissants de façon linéaire suivant les directions x ou y dans les pièces polaires. On obtient ainsi des champs de gradients constants selon ces directions et, si on applique simultanément le courant dans les deux enroulements 1a, 1b d'une part et 2a, 2b d'autre part, on obtient par superposition d'état un gradient de champ dirigé dans le plan xOy.

De manière pratique, les bobinages sont réalisés soit avec du fil isolant encerclant les pièces polaires 1 et 2, soit par gravure sur circuit imprimé dont les deux plans sont ainsi réunis par des bandes ou fils de liaison rigides. Conformément à l'invention, les nappes 1a et 1b d'une part sont parcourues en série par la même intensité ainsi que les nappes 2a et 2b d'autre part.

La longueur des pièces polaires 1 et 2 étant grande par rapport à l'épaisseur de l'entrefer nécessaire pour l'homogénéité du champ

$$\vec{B_0},$$

on obtient ainsi facilement des gradients constants à plus ou moins 1% près sur environ la moitié de chacune des plaques polaires 1 et 2. Si l'on souhaite augmenter encore l'homogénéité du champ continu

$$\vec{B_0},$$

on peut améliorer la zone d'homogénéité du gradient précédent en modifiant légèrement l'espacement des conducteurs des nappes 1a, 2a et 1b, 2b précédentes près des extrémités des plaques ou ce qui revient au même en superposant à des nappes régulières quelques ampères-tours supplémentaires. Cette correction est de même nature que celle du champ continu

$$\vec{B_0}$$

que l'on obtient dans les aimants permanents à l'aide des systèmes d'anneaux de garde.

On expliquera maintenant en se référant à la figure 3 le principe du fonctionnement du système de bobines de la figure 2 qui est le suivant. Pour ce faire, on calculera la circulation du vecteur champ H le long de la boucle fermée 7 parcourant à la fois l'entrefer de dimension E et les pièces polaires 1 et 2 supposées en un matériau de perméabilité suffisamment forte ($\mu \geqslant 100$) pour que l'on puisse supposer nulle la force magnétomotrice nécessaire pour la circulation du champ dans ces pièces polaires proprement dites. Dans ces conditions, si l'on appelle +X et -X les abscisses extrêmes de la boucle 7, le théorème d'Ampère s'écrit alors le long de cette boucle 7 :

$$2Bz\ (X)\ .\ E\ =\ 4\mu_0 \int_0^X i_x dx \qquad (1)$$

formule dans laquelle E est la largeur de l'entrefer, $i_x$ est la densité linéique de courant à la cote x et s'exprime en A.m$^{-1}$, $\mu_0$ vaut dans le système SI $4\pi.10^{-7}$ A.s.V$^{-1}$.m$^{-1}$.

La condition à réaliser pour le gradient Gx étant par définition Bz(X)=Gx.X, il en résulte :

$$i\ =\ \frac{Gx\ .E}{2\mu_0}\ =\ constante \qquad (2)$$

L'équation 2 montre que la proportionnalité de la composante Bz(X) à l'abscisse X est obtenue automatiquement par une densité de courant i constante dont la valeur est donnée par l'équation 2.

Ce calcul permet de vérifier que la structure des figures 2 et 3 permet bien, à l'aide de la nappe 1a, 1b de bobines entourant les pièces polaires 1 et 2, de créer dans l'entrefer un champ additionnel dont le gradient Gx est constant dès lors que les bobines de pas constant sont parcourues en série par un courant I.

Sur la figure 4, on a décrit un des modes de réalisation possible des bobines de structure circulaire concentrique centrées sur l'axe Oz destinées à produire le gradient Gz. Conformément à l'invention, cette bobine comporte des spires réparties de la façon suivante. A la distance r du centre 0 est située une spire référencée 8, à la distance 2r du centre 0 se trouvent trois spires référencées 9 et à la distance 3r du centre 0 se trouvent cinq spires référencées 10. Toutes ces spires sont évidemment en série entre une entrée 11 et une sortie 12 et deux ensembles tels que celui de la figure 4 se font face sur les deux pièces polaires 1 et 2, chacun de ces ensembles étant parcouru par la même intensité i circulant en sens inverse du sens de circulation dans l'autre bobine. Le nombre de groupes de spires n'est pas limitatif. Dans la pratique on prendra un pas entre chaque groupe de l'ordre du centimètre.

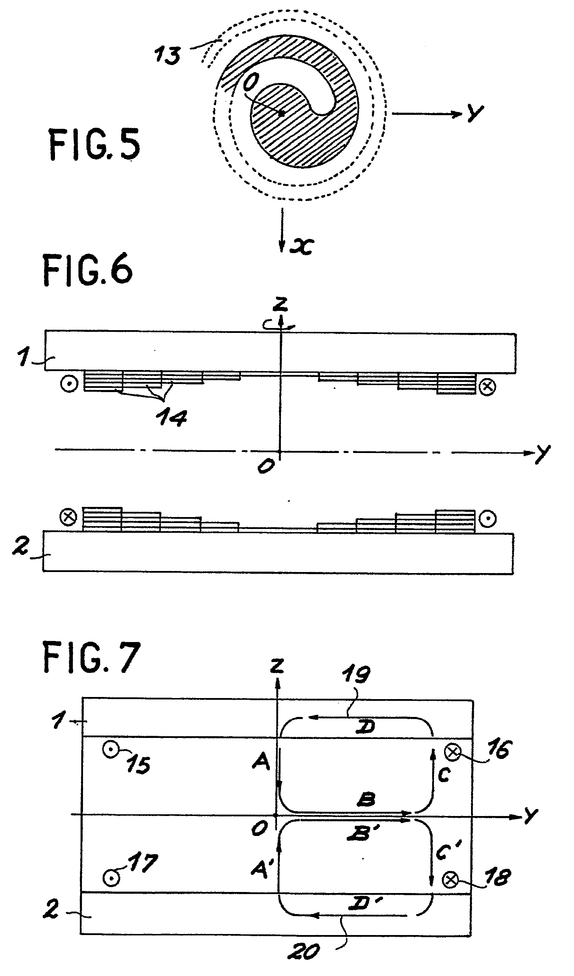

Sur la figure 5, on a représenté une bobine de création du gradient Gz qui comporte autour de l'axe Oz, sur la face plane de la pièce polaire tournée vers l'entrefer, un circuit imprimé 13 en forme de spirale dont l'espacement entre les différentes bandes va en se rétrécissant au fur et à mesure que l'on s'éloigne du centre 0, de façon à ce que l'intensité de courant qui circule perpendiculairement à l'un des plans xOz ou yOz entre le centre 0 et un point distant de r, soit proportionnelle au carré de la distance r au centre 0.

Sur la figure 6, une variante de réalisation de la bobine créatrice du gradient Gz est représentée, dans laquelle cette bobine comporte un certain nombre de spires plates telles que 14 assemblées selon des zones concentriques dont chacune a la largeur d'une spire. On réalise ainsi un empilement de profil conique dans le plan de la figure qui est le plan yOz de la figure 1. Bien entendu, les différentes spires ainsi empilées sont isolées les unes des autres, montées en série et parcourues par des courants dont les sens marqués sur la figure 6 sont opposés quand on passe de la bobine recouvrant la pièce polaire 1 à la bobine recouvrant la pièce polaire 2. La répartition des différentes spires plates élémentaires répond à la condition selon laquelle le nombre de spires dans un plan zOy depuis le centre jusqu'à la distance r de l'axe Oz est proportionnel à r$^2$.

Le principe de fonctionnement des bobines des figures 4, 5 et 6 sera décrit maintenant en se référant à la figure 7 dans laquelle on voit les pièces polaires 1 et 2 en coupe selon le plan yOz. Sur cette figure, deux bobines de création du gradient Gz conforme à l'invention ont été schématisées par les conducteurs supérieurs 15 et 16 et inférieurs 17 et 18.

Si l'on considère maintenant un volume cylindrique de rayon R centré sur l'axe Oz d'épaisseur dz à la hauteur Z, le flux entrant par la face supérieure de ce volume est $Bz.S=Gz.(Z+dz).\pi R^2$, le flux sortant par la face inférieure de ce même volume est $Gz.(Z).\pi R^2$ La différence entre ces deux flux doit être égale au flux s'échappant par les parois latérales, soit : $Gz.dz.\pi R^2=Br.2\pi R.dz$ ou encore :

$$Br\ (R)\ =\ \frac{Gz\ .\ R}{2}\qquad(3)$$

formule dans laquelle Br (R) est l'induction radiale à la distance R du centre.

En revenant maintenant à la figure 7, on examinera deux chemins fermés 19 et 20 sortant des pièces polaires suivant l'axe Z (A et A') puis un trajet commun dans le plan médian (B et B') puis deux trajets parallèles à l'axe Z entrant dans les pièces polaires (C et C') pour se refermer selon deux trajets (D et D').

La circulation du champ est nulle pour les trajets D et D' dans les pièces polaires (perméabilité $\mu_{rel} >$ 100), elle est opposée pour les portions A et C ainsi que A' et C' (composante Bz). Il ne reste que la circulation de Br le long de B et B' qui permet d'écrire :

$$\int_{o}^{R}\ \frac{1}{2}\ Br.dr\ =\ \mu_o\int_{o}^{R}\ ir.dr$$

formule dans laquelle ir est la densité de courant linéique dans les bobines 15-16 et 17-18, soit

$$ir\ =\ \frac{1}{2\mu_o}\ Br.$$

D'où finalement par rapprochement avec l'égalité (3) précédente :

$$ir\ (R)\ =\ \frac{Gz\ .\ R}{4\mu_o}\qquad(4)$$

Cette dernière formule (4) signifie que, pour créer des gradients Gz, il suffit de tapisser les faces en regard des pièces polaires de nappes de courant circulaires centrées sur cet axe z et dont la densité linéique $i_r$ croît linéairement comme r. Cette condition conduit en effet pratiquement à réaliser des bobines concentriques dont le nombre de spires croît de manière telle que la somme totale des spires intérieures dans un cercle de rayon r soit proportionnelle au carré de la distance r au centre.

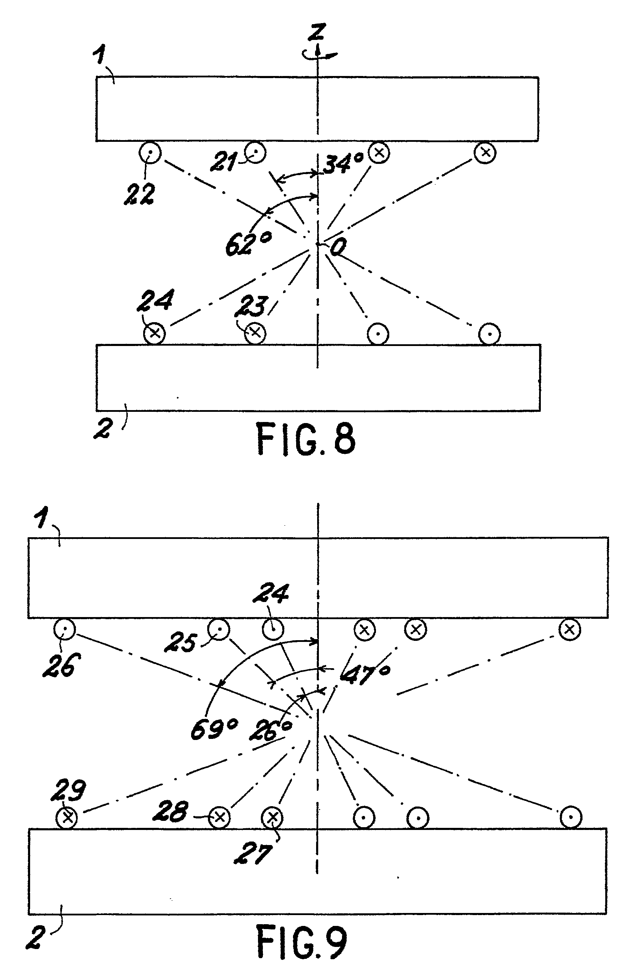

On décrira maintenant en se référant aux figures 8 et 9 deux types de bobines particulières, toujours d'axe Oz, pour créer des gradients Gz, mais sous forme de bobines discrètes dont la position et le nombre de tours sont déterminés par des abaques et calculs issus de la théorie des polynômes de Legendre.

Sur la figure 8, où l'on a représenté encore une fois schématiquement les pièces polaires 1 et 2, on a logé contre ces pièces polaires 1 et 2 quatre bobines 21, 22, 23 et 24 qui sont situées respectivement à l'intersection des faces polaires et de cônes circulaires d'axe Oz dont le sommet est situé en 0 et de demiangles au sommet d'ouverture $\theta_1 = 34°$ et $\theta_2 = 62°$. Le rapport du nombre de spires entre les bobines 21 et 22 ou 23 et 24 est le plus voisin possible de 1 à 8,66 et les sens des courants, figurés schématiquement sur la figure 8 par les signes conventionnels classiques, sont, comme toujours dans la présente invention, inversés d'une pièce polaire à l'autre.

Sur la figure 9, on a représenté une structure de même nature que celle de la figure 8 mais comportant sur chaque pièce polaire trois bobines au lieu des deux précédentes ; elles sont référencées respectivement 24, 25 et 26 pour la pièce polaire 1 et 27, 28 et 29 pour la pièce polaire 2. Conformément à l'invention, ces bobines sont situées à l'intersection des pièces polaires 1 et 2 avec des cônes cylindriques de révolution d'axe Oz et de demi-angles aux sommets respectifs 26° pour le premier cône, 47° pour le second et 69° pour le troisième. Les rapports des nombres de spires dans chacune des bobines sont, du centre à la périphérie, de l'ordre de 1 à 3,89 et 31,85. Comme précédemment, les sens de courant figurés sur les bobines sont inversés lorsque l'on passe de la pièce polaire 1 à la pièce polaire 2.

Comme on le voit dans toutes les réalisations qui viennent d'être décrites précédemment, les systèmes de bobines objet de l'invention sont situés tout contre les faces des pièces polaires en regard de l'aimant de polarisation et ne conduisent pratiquement de ce fait à aucune perte de place pour l'espace réservé dans l'entrefer au logement du patient à examiner.

## Revendications

1. Système de bobines de production de champs additionnels dans un aimant comportant deux pièces polaires (1, 2) pour imagerie par résonance magnétique nucléaire dans une configuration où le champ de polarisation

$$\overrightarrow{Bo},$$

perpendiculaire aux pièces polaires, est parallèle à la direction Oz d'un trièdre trirectangle de référence, et les pièces polaires (1, 2), rectangulaires ou circulaires présentent chacune deux faces opposées et ont leurs côtés parallèles aux directions Ox et Oy de ce même trièdre, pour l'obtention de champs de polarisation résultants

$$\vec{B}$$

dont la composante

$$\vec{Bz}$$

selon la direction Oz a des gradients constants Gx, Gy, Gz selon les trois directions de l'espace, caractérisé en ce qu'il comprend :
- pour la création des gradients

$$Gx = \frac{\partial Bz}{\partial x} \quad et \quad Gy = \frac{\partial Bz}{\partial y}$$

deux nappes d'enroulements orthogonales (1a, 1b, 2a, 2b), une sur chaque pièce polaire (1, 2), chacune étant constituée de conducteurs parallèles à l'un des axes Ox ou Oy et uniformément répartis, et étant alimentée de telle sorte que les courants circulent dans la même direction sur les faces internes de l'entrefer,
- pour la création du gradient

$$Gz = \frac{\partial Bz}{\partial z},$$

deux systèmes d'enroulement (8; 9; 10; 13; 14) de symétrie circulaire d'axe Oz, chaque système étant situé sur une face interne respective en regard d'une pièce polaire et parcouru par des courants de sens opposés à ceux des courants parcourant l'autre système.

2. Système de bobines selon la revendication 1, caractérisé en ce que les enroulements de création des gradients Gx et Gy ont leurs conducteurs de retour de courant situés sur la face opposée à la face sur laquelle sont situés les conducteurs d'aller de courant, chaque pièce polaire étant enveloppée par les conducteurs qui parcourent ses deux faces.

3. Système de bobines selon la revendication 1, caractérisé en ce que les enroulements de création des gradients Gx et Gy ont leurs conducteurs d'aller de courant situés à la surface des pièces polaires, les conducteurs de retour de courant étant situés dans une zone de l'espace éloignée des pièces polaires.

4. Système de bobines selon la revendication 1, caractérisé en ce que le système d'enroulement d'axe Oz est composé de deux bobines symétriques situées sur les pièces polaires et conçues chacune de façon telle que l'intensité de courant qui traverse un plan passant par l'axe Oz entre le centre de la bobine et un point distant de r de cet axe soit proportionnelle à r².

5. Système de bobines selon la revendication 4, caractérisé en ce qu'il est constitué de spires circulaires concentriques 8, 9, 10 dont la répartition spatiale croît en fonction du rayon de façon telle que la somme totale des spires intérieures à un cercle de rayon r soit proportionnelle à r².

6. Système de bobines selon la revendication 5, caractérisé en ce que les spires (8, 9, 10) sont réparties selon des groupements situés à des distances r, 2r, 3r,... de l'axe Oz, le nombre de spires des groupements successifs étant égal aux termes de la suite des nombres impairs 1, 3, 7..., (2n+1).

7. Système de bobines selon la revendication 4, caractérisé en ce que le système d'enroulement d'axe Oz est réalisé à l'aide d'un circuit imprimé (13) en forme de spirale dont l'espacement entre les bandes va en se rétrécissant au fur et à mesure que l'on s'éloigne du centre de façon à respecter la loi de répartition du courant proportionnellement à r² selon la direction radiale.

8. Système de bobines selon la revendication 5, caractérisé en ce que le système d'enroulement d'axe Oz est réalisé par un empilement des pires plates contiguës (14) et en série, selon un profil conique dans un plan passant par Oz et respectant la loi du nombre de spires proportionnel à r² dans un cercle de rayon r.

9. Système de bobines selon la revendication 1, caractérisé en ce que le système d'enroulement de symétrie circulaire d'axe z est constitué de bobines discrètes (21, 22, 24,25, 26) localisées sur les sections droites de cônes circulaires de sommet 0, centre de l'entrefer, d'axe Oz et de demi-angles au sommet θ.

10. Système de bobines selon la revendication 9, caractérisé en ce que les bobines, au nombre de deux (21, 22, 23, 24) sur chaque pièce polaire, comportent respectivement des nombres de spires dans le rapport de l'ordre de 1 à 8,66 et sont situées sur des cônes de demi-angles au sommet voisins de $\theta_1 = 34°$ et $\theta_2 = 62°$.

11. Système de bobines selon la revendication 9, caractérisé en ce que les bobines (24, 25,26) au nombre de trois sur chaque pièce polaire, comportent respectivement des nombres de spires dans les rapports de l'ordre de 1 à 3,89 et 31,85 et sont situées sur des cônes de demi-angles au sommet voisins de $\theta_1 = 26°$, $\theta_2 = 47°$ et $\theta_3 = 69°$.

**Claims**

1. System of coils for producing additional fields in a magnet having two pole pieces (1, 2) for image production by nuclear magnetic resonance in a configuration where the polarization field

$$\vec{Bo},$$

perpendicular to the pole pieces, is parallel to the direction of a trirectangular reference trihedron, and the rectangular or circular pole pieces (1, 2) each have two opposite faces and their sides parallel to the directions Ox and Oy of said same trihedron for obtaining resultant polarization fields

$$\vec{B},$$

whose component

$$\vec{Bz}$$

in direction Oz has constant gradients Gx, Gy and Gz in three directions in space, characterized in that it comprises for producing gradients

$$Gx = \frac{\partial Bz}{\partial z}$$

and

$$Gy = \frac{\partial Bz}{\partial y},$$

two orthogonal winding layers (1a, 1b; 2a, 2b), one on each pole piece (1, 2), each being constituted by conductors parallel to one of the axes Ox or Oy and uniformly distributed, whilst being supplied in such a way that the currents flow in the same direction on the internal faces of the air gap and for producing the gradient

$$Gz = \frac{\partial Bz}{\partial z},$$

there are two winding systems (8, 9, 10, 13, 14) of circular symmetry and axis Oz, each system being located on one respective inner facing faces of a pole piece and traversed by currents of opposite directions to those of the currents passing through the other system.

2. System of coils according to claim 1, characterized in that the windings for producing the gradients Gx and Gy have their "return" current conductors located on the face opposite to that on which are located the "outward" current conductors, each pole piece being enveloped by the conductors passing through its two faces.

3. System of coils according to claim 1, characterized in that the windings for producing gradients Gx and Gy have their "outward" current conductors located on the surface of the pole pieces, the "return" current conductors being located in a zone in space remote from the pole pieces.

4. System of coils according to claim 1, characterized in that the winding system of axis Oz comprises two symmetrical coils located on the pole pieces and each designed in such a way that the current intensity passing through a plane passing through the axis Oz between the coil centre and a point spaced by r from axis is proportional to $r^2$.

5. System of coils according to claim 4, characterized in that it is constituted by circular concentric turns (8, 9, 10), whose spatial distribution increases as a function of the radius, in such a way that the total sum of the turns within a circle of radius r is proportional to $r^2$.

6. System of coils according to claim 5, characterized in that the turns are distributed in groups located at distances r, r2, r3, etc. from axis Oz, the number of turns (8, 9, 10) of successive groups being equal to the terms of the sequence of uneven numbers, 1, 3, 7, etc., (2n+1).

7. System of coils according to claim 4, characterized in that the winding system of axis Oz is obtained with the aid of a spiral printed circuit (13), whereof the spacing between the bands narrows on moving away from the centre, so as to respect the current distribution law proportionally to $r^2$ in accordance with the radial direction.

8. System of coils according to claim 5, characterized in that the winding system of axis Oz is obtained by a stack of flat contiguous turns (14) in series in accordance with a conical profile, in a plane passing through Oz and respecting the law of the number of turns proportional to $r^2$ in a circle of radius r.

9. System of turns according to claim 1, characterized in that the winding system of circular symmetry and axis z is constituted by discrete coils (21, 22, 24, 25, 26), located on the cross-sections of circular cones of apex O, the centre of the air gap, of axis Oz and half-angles at the apex θ.

10. System of coils according to claim 9, characterized in that the two coils (21, 22, 23, 24) on each pole piece respectively have numbers of turns in the ration approximately 1 to 8.66 and are located on cones of half-angles at the apex close to $\theta_1 = 34°$ and $\theta_2 = 62°$.

11. System of coils according to claim 9, characterized in that the three coils (24, 25, 26) on each pole piece respectively have numbers of turns in ratios of approximately 1 to 3.89 and 31.85 and located on cones of half-angles at the apex close to $\theta_1 = 26°$, $\theta_2 = 47°$ and $\theta_3 = 69°$.

**Patentansprüche**

1. Spulensystem zur Erzeugung von Zusatzfeldern in einem Magnet, mit zwei polaren Teilen (1, 2) für die Abbildung durch nukleare Magnetresonanz in eine Konfiguration, wo das Polarisationsfeld

$$\vec{Bo},$$

senkrecht zu den Polteilen, parallel ist zur Richtung Oz eines dreirechteckigen Referenztrieders, und die Polteile (1, 2), rechteckig oder kreisförmig, jeweils zwei einander gegenüberliegende Seiten aufweisen und ihre Seiten parallel zu den Richtungen Ox und Oy desselben Trieders haben, zur Erreichung von resultierenden Polarisationsfeldern

$$\vec{E},$$

dessen Komponente

$$\vec{Bz}$$

gemäß der Richtung Oz konstante Gradienten Gx, Gy, Gz gemäß den drei Raumrichtungen hat, dadurch gekennzeichnet, daß es aufweist:
– für die Erzeugung der Gradienten

$$Gx = \frac{\partial Bz}{\partial x}$$

und

$$G_y = \frac{\partial \mathcal{B}_z}{\partial y}$$

zwei orthogonale Wicklungsbahnen (1a, 1b; 2a, 2b) eine auf jedem Polteil (1, 2), wobei jede aus Leitern gebildet ist, die parallel zu einer der Achsen Ox oder Oy und gleichmäßig verteilt sind, und derart gespeist sind, daß die Ströme in derselben Richtung auf den Innenseiten des Luftspalts zirkulieren,
– für die Erzeugung des Gradienten

$$G_z = \frac{\partial \mathcal{B}_z}{\partial z} \quad z$$

zwei Wicklungssysteme (8; 9; 10; 13; 14) von zur Achse Oz kreisförmiger Symmetrie, wobei jedes System auf einer Innenseite entsprechend gegenüber einem Polteil angeordnet ist und von den Strömen in Gegenrichtung zu jenen der Ströme, die das andere System durchlaufen, durchlaufen werden.

2. Spulensystem nach Anspruch 1, dadurch gekennzeichnet, daß die Wicklungen der Erzeugung der Gradienten Gx und Gy ihre Stromrückleiter auf der Seite angeordnet haben, die der Seite gegenüberliegt, auf der die stromhinführenden Leiter angeordnet sind, wobei jedes Polteil von den Leitern umwickelt ist, die seine beiden Seiten durchlaufen.

3. Spulensystem nach Anspruch 1, dadurch gekennzeichnet, daß die Wicklungen der Erzeugung der Gradienten Gx und Gy ihre Stromzufuhrleiter an der Oberfläche der Polteile angeordnet haben, wobei die Stromrückführleiter in einer Zone eines von den Polteilen entfernten Raumes angeordnet sind.

4. Spulensystem nach Anspruch 1, dadurch gekennzeichnet, daß das Wicklungssystem um die Achse Oz aus zwei symmetrischen Spulen gebildet ist, die auf den Polteilen angeordnet sind und jeweils derart ausgestaltet sind, daß die Stromintensität, die eine durch die Achse Oz zwischen dem Zentrum der Spule und einem um r von dieser Achse entfernten Punkt gehende Ebene durchquert, gleich proportional zu $r^2$ ist.

5. Spulensystem nach Anspruch 4, dadurch gekennzeichnet, daß es aus konzentrischen kreisförmigen Wicklungen (8, 9, 10) gebildet ist, deren räumliche Verteilung in Abhängigkeit des Radius derart zunimmt, daß die Gesamtsumme der inneren Wicklungen für einen Kreis vom Radius r proportional gleich $r^2$ ist.

6. Spulensystem nach Anspruch 5, dadurch gekennzeichnet, daß die Wicklungen (8, 9, 10) gemäß Gruppierungen verteilt angeordnet sind, die in Abständen r, 2r, 3r, ... um die Achse Oz angeordnet sind, wobei die Anzahl der Wicklungen der aufeinanderfolgenden Wicklungen gleich der aufeinanderfolgenden ungeraden Zahlen 1, 3, 7 ..., $(2n+1)$ ist.

7. Spulensystem nach Anspruch 4, dadurch gekennzeichnet, daß das Wicklungssystem der Achse Oz verwirklicht wird unter Hilfe einer gedruckten Schaltung (13) in Form einer Spirale, deren Ausdehnung zwischen den Bändern sich allmählich entsprechend der Entfernung vom Zentrum derart verringert, daß das Gesetz der Stromverteilung proportional zu $r^2$ in radialer Richtung eingehalten wird.

8. Spulensystem nach Anspruch 5, dadurch gekennzeichnet, daß das Wickelsystem der Achse Oz durch ein Aufeinanderschichten von flachen aneinandergrenzenden Wicklungen (14) und in Reihe gemäß einem konischen Profil in einer Ebene, die durch Oz geht, verwirklicht wird, und das Gesetz der Anzahl der Wicklungen proportional zu $r^2$ in einem Kreis mit Radius r erfüllt.

9. Spulensystem nach Anspruch 1, dadurch gekennzeichnet, daß das Wicklungssystem mit kreisförmiger Symmetrie zur Achse z aus einzelnen Spulen (21, 22, 24, 25, 26) gebildet ist, die an den geraden Abschnitten der kreisförmigen Konusse der Spitze O dem Zentrum des Luftspalts, der Achse Oz und der Halbwinkel an der Spitze θ angeordnet ist.

10. Spulensystem nach Anspruch 9, dadurch gekennzeichnet, daß die Spulen mit einer Anzahl von zwei (21, 22, 23, 24) auf jedem Polteil jeweils eine Anzahl von Wicklungen im Verhältnis der Größenordnung von 1 bis 8,66 aufweisen und auf der Spitze auf Halbwinkelkonussen angeordnet sind in der Nähe von $\theta_1 = 34°$ und $\theta_2 = 62°$.

11. Spulensystem nach Anspruch 9, dadurch gekennzeichnet, daß die Spulen (24, 25, 26) in der Anzahl von drei auf jedem Polteil, Wicklungsanzahlen im Größenordnungsverhältnis von 1 bis 3,89 bzw. 31,85 aufweisen und auf Konussen angeordnet sind, mit Spitzenhalbwinkeln in der Nähe von $\theta_1 = 26°$, $\theta_2 = 47°$ und $\theta_3 = 69°$.

FIG.1

FIG. 2

EP 0 178 216 B1

FIG.3

FIG.4

**FIG.5**

**FIG.6**

**FIG.7**

EP 0 178 216 B1

FIG. 8

FIG. 9